# EUROPÄISCHE PATENTANMELDUNG

(11) **EP 4 650 939 A1**
(43) Veröffentlichungstag der Anmeldung: **19.11.2025**
(21) Anmeldenummer: 25171887.0
(22) Anmeldetag: 23.04.2025
(51) Int. Cl.: G06F 7/58, H03K 3/84

(54) **VERFAHREN UND VORRICHTUNG ZUR ERZEUGUNG EINER ZUFALLSZAHL**

(30) Priorität: 16.05.2024 DE 102024204563
(71) Anmelder: Forschungszentrum Jülich GmbH, 52428 Jülich (DE)
(72) Erfinder: SCHNIEDERS, Kristoffer, 49757 Werlte (DE); WANG, Yongmin, 52428 Jülich (DE); BAI, Peixuan, 52062 Aachen (DE)
(74) Vertreter: Gille Hrabal Partnerschaftsgesellschaft mbB Patentanwälte

(57) **Zusammenfassung**

Die Erfindung betrifft ein Verfahren zur Erzeugung einer Zufallszahl mit den Schritten:
ein erstes Eingangssignal (I(t)) wird erzeugt, das sich mit der Zeit (t) zufällig ändert,
ein zweites Eingangssignal (I(t+Δt) wird erzeugt, das sich mit der Zeit zufällig ändert,
das erste Eingangssignal (I(t)) wird mit dem zweiten Eingangssignal (I(t+Δt) verglichen,
in Abhängigkeit von dem Ergebnis des Vergleichs wird entweder eine erste logische 0 oder eine erste logische 1 erzeugt und damit ein erstes Bit einer binären Zufallszahl,
nach dem Erzeugen des ersten Bits der binären Zufallszahl werden die Schritte mehrfach wiederholt, um weitere Bits der binären Zufallszahl zu erzeugen.

Die Erfindung betrifft außerdem einen Zufallszahlengenerator zur Erzeugung einer Zufallszahl gemäß dem beanspruchten Verfahren mit einem Memristor und einem Messgerät für ein Auslesen eines Widerstandswerts des Memristors zur Erzeugung eines Eingangssignals (I(t), das sich mit der Zeit zufällig ändert. Der Zufallszahlengenerator umfasst eine Verzögerungseinrichtung (2), die das erzeugte Eingangssignal (I(t) zeitlich verzögert, einen Komparator (1), der das Eingangssignal I(t)) mit dem zeitlich verzögerten Eingangssignal (I(t+Δt) vergleicht und der durch Vergleiche Bits einer ersten Zufallszahl gemäß einer ersten Frequenz erzeugt. Der Zufallszahlengenerator umfasst eine erste Verarbeitungseinrichtung (3), die Bits der ersten erzeugten Zufallszahl gemäß einer zweiten Frequenz (CLK 1) in Bits einer zweiten Zufallszahl umwandelt, und eine zweite Verarbeitungseinrichtung (4), die Bits der zweiten erzeugten Zufallszahl gemäß einer dritten Frequenz (CLK 2) in Bits einer dritten Zufallszahl umwandelt. Die erste Frequenz ist kleiner als die zweite Frequenz (CLK 1). Die zweite Frequenz (CLK 1) ist kleiner als die dritte Frequenz (CLK 2).

## Beschreibung

Die Erfindung betrifft ein Verfahren und einen Zufallszahlengenerator zur Erzeugung einer Zufallszahl.

Eine Zufallszahl kann eine kryptographisch geeignete Zufallszahl sein. Eine kryptographisch geeignete Zufallszahl ist eine für kryptografische Anwendungen entwickelte Zahl. Eine kryptographisch geeignete Zufallszahl soll nicht vorhersagbar sein, um für sichere Verschlüsselungszwecke verwendet werden zu können.

Ein kryptographisch geeigneter Zufallszahlengenerator ist ein für die Kryptologie geeigneter Generator für Zufallszahlen.

In einem digitalen System steht die logische 0 für einen Zustand mit niedrigem Spannungsniveau und die logische 1 für einen Zustand mit hohem Spannungsniveau. Ein kryptographisch geeigneter Zufallszahlengenerator kann eine zufällige Folge von Zuständen mit niedrigem und hohem Spannungsniveau erzeugen und in diesem Sinn eine kryptographisch geeignete Zufallszahl.

Es ist Aufgabe der Erfindung, ein Verfahren und einen Zufallszahlengenerator zur Erzeugung einer Zufallszahl zu schaffen.

Zur Lösung der Aufgabe können ein Verfahren und ein Zufallszahlengenerator wie folgt sein.

Es kann ein erstes Eingangssignal erzeugt werden, das sich mit der Zeit zufällig ändert. Es kann zweites Eingangssignal erzeugt werden, das sich mit der Zeit zufällig ändert.

Das erste Eingangssignal kann mit dem zweiten Eingangssignal verglichen werden. Das erste Eingangssignal kann so sein, dass es größer als das zweite Eingangssignal ist. Das erste Eingangssignal kann so sein, dass es kleiner als das zweite Eingangssignal ist. Die beiden Eingangssignale können zumindest temporär um einen Mittelwert herum schwanken. Die Mittelwerte der beiden Eingangssignale können ähnlich oder gleich sein.

In Abhängigkeit von dem Ergebnis des Vergleichs kann entweder eine erste logische 1 oder eine erste logische 0 erzeugt werden. Es kann so das erste Bit einer binären Zufallszahl erzeugt werden.

Nach dem Erzeugen des ersten Bits einer binären Zufallszahl werden die Schritte wiederholt, um eine zweite logische 1 oder eine zweite logische 0 zu erzeugen, also ein zweites Bit der binären Zufallszahl.

Es können anschließend die Schritte mehrfach wiederholt werden, um weitere Bits der binären Zufallszahl zu erzeugen.

In dieser Weise kann das Verfahren fortgesetzt werden, bis eine so erzeugte binäre Zufallszahl die gewünschte Länge erreicht hat, also eine gewünschte Anzahl an Bits. Zum Beispiel hat die binäre Zahl 0010 vier Bits. Die binäre Zahl 10100 hat fünf Bits.

Ergibt ein Vergleich beispielsweise, dass das erste Eingangssignal größer oder gleich dem zweiten Eingangssignal ist, dann kann eine logische 1 erzeugt werden. Andernfalls kann eine logische 0 erzeugt werden. Durch das Verfahren kann so eine zufällige Folge aus logischen Nullen und logischen Einsen gebildet werden. Es kann so eine binäre Zufallszahl erzeugt werden, die digital verarbeitet werden kann.

Aus der erzeugten binären Zufallszahl, nachfolgend auch "erste erzeugte Zufallszahl" genannt, kann eine andere binäre Zufallszahl erzeugt werden, um zu vermeiden, dass eine erzeugte Zufallszahl durch einen unbefugten Dritten ermittelt werden kann und/oder um die Geschwindigkeit zur Erzeugung einer Zufallszahl mit einer gewünschten Anzahl an Stellen zu erhöhen.

Beispielsweise können durch Vergleichen von zwei Eingangssignalen Bits der ersten binären Zufallszahl gemäß einer ersten Frequenz erzeugt werden. Während der Erzeugung eines Bits gemäß der ersten Frequenz kann ein bereits erzeugtes Bit der ersten binären Zufallszahl gemäß einer zweiten Frequenz bearbeitet werden. Die zweite Frequenz kann durch ein periodisches Signal vorgegeben werden. Während eines Taktes der zweiten Frequenz kann beispielsweise aus einer logischen 0 eines Bits der ersten binären Zufallszahl eine logische 0 der zweiten binären Zufallszahl erzeugt werden. Aus einer logischen 1 eines Bits der ersten binären Zufallszahl kann eine logische 1 der zweiten binären Zufallszahl erzeugt werden. Während des Taktes einer ersten Frequenz kann also ein Bit der ersten erzeugten Zufallszahl gemäß einer zweiten Frequenz durch Bearbeitung in ein Bit der zweiten binären Zufallszahl umgewandelt werden.

Unterscheiden sich die beiden Frequenzen, so kann es passieren, dass ein Bit der ersten Zufallszahl verdoppelt wird oder dass ein Bit der ersten Zufallszahl ausgelassen wird. Beispielsweise sei ein Bit einer ersten Zufallszahl eine logische 1. Ist die zweite Frequenz größer als die erste Frequenz, dann kann es passieren, dass diese logische 1 der ersten Zufallszahl in zwei logische Einsen der zweiten Zufallszahl umgewandelt wird, also in zwei Bits. Ist die zweite Frequenz kleiner als die erste Frequenz, dann kann es passieren, dass diese logische 1 der ersten Zufallszahl nicht in ein Bit der zweiten Zufallszahl umgewandelt und folglich ausgelassen wird. Eine erste binäre Zahl kann so also in eine andere binäre Zahl umgewandelt werden. Die beiden Zahlen können sich u. a. durch die Zahl der Bits unterscheiden. Die Vorhersagbarkeit einer Zufallszahl kann so erschwert werden.

Zu bevorzugen ist, dass die zweite Frequenz größer als die erste Frequenz ist, um die Zahl der pro Zeiteinheit erzeugten Bits einer Zufallszahl zu vergrößern.

Kann die erste Zahl aus technischen Gründen nur mit einer begrenzt großen Frequenz erzeugt werden und kann die resultierende erste Zufallszahl mit einer größeren zweiten Frequenz in eine zweite binäre Zufallszahl umgewandelt werden, dann kann das Erzeugen einer Zufallszahl mit einer gewünschten Anzahl an Bits beschleunigt werden.

Die erzeugte erste binäre Zufallszahl kann auch auf andere Weise in eine zweite binäre Zufallszahl umgewandelt werden, so zum Beispiel mithilfe eines Schiebregisters. Schieberegister sind Schaltungen, die mehrstellige binäre Signale taktgesteuert aufnehmen, speichern und wieder abgeben können.

Um eine binäre Zahl in eine andere binäre Zahl mit einem Schieberegister umzuwandeln, kann man das Schieberegister verwenden, um die Bits der Zahl entsprechend zu verschieben. Zuerst können die Bits der ursprünglichen binären Zahl parallel in das Schieberegister geladen werden. Das Schieberegister kann dann um eine gewünschte Anzahl von Stellen verschoben werden. Die verschobenen Bits können aus dem Schieberegister ausgelesen werden, um die neue binäre Zahl zu erhalten.

Ein Schieberegister kann gemäß einer Frequenz Bits verschieben, die durch ein periodisches Signal vorgegeben sein kann. Durch die Frequenz kann festgelegt werden, wie viele Schiebeoperationen pro Zeiteinheit das Schieberegister ausführen kann. Die Frequenz eines Schieberegisters kann sich von der Frequenz unterscheiden, mit der zuvor erzeugte Bits einer Zufallszahl in das Schieberegister beispielsweise seriell geschoben werden. Es kann so eine zuvor erzeugte Zufallszahl in eine andere Zufallszahl umgewandelt werden, die nur unter der Voraussetzung vorhergesagt werden kann, dass die Frequenz, mit der das Schieberegister arbeitet, bekannt ist. Vorzugsweise ist die Frequenz, mit der das Schieberegister arbeitet, größer als die Frequenz, mit der Bits in das Schieberegister geschoben werden. Die Zahl der pro Zeiteinheit erzeugten Bits einer Zufallszahl kann so vergrößert werden.

Es kann ein nichtlineares Schieberegister verwendet werden, um eine binäre Zahl auf nichtlineare Weise zu ändern. Ein nichtlineares Schieberegister (NLFSR) ist ein Schieberegister, dessen Eingangsbit eine nichtlineare Funktion seines vorherigen Zustands ist. Die Vorhersehbarkeit einer Zufallszahl kann so weiter erschwert werden.

Um die Sicherheit und/oder die Geschwindigkeit der Erzeugung einer Zufallszahl weiter verbessern zu können, kann die erzeugte zweite binäre Zufallszahl in eine dritte binäre Zufallszahl umgewandelt werden. Dies kann auf eine der vorbeschriebenen Weisen geschehen, also zum Beispiel mithilfe eines nichtlinearen Schieberegisters.

Vorzugsweise wird eine jede erzeugte Zufallszahl auf eine andere Weise erzeugt. Eine erste erzeugte Zufallszahl kann also beispielsweise durch Vergleich von analogen Signalen erzeugt werden. Aus der ersten erzeugten Zufallszahl kann eine zweite Zufallszahl durch digitale Bearbeitung erzeugt werden. Aus der zweiten erzeugten Zufallszahl kann eine dritte Zufallszahl durch digitale Bearbeitung erzeugt werden. Die beiden digitalen Bearbeitungen können sich unterscheiden, um die Vorhersehbarkeit der zuletzt erzeugten Zufallszahl besonders zu erschweren. Es ist möglich, mit drei unterschiedlichen Frequenzen zu erzeugen, um die Vorhersehbarkeit zu erschweren. Vorzugsweise werden die Frequenzen immer größer, um die Effizienz der Erzeugung einer Zufallszahl zu maximieren. Eine erste Frequenz, mit der eine erste Zufallszahl erzeugt wird, ist dann kleiner als die Frequenz, mit der eine zweite Zufallszahl aus der ersten Zufallszahl erzeugt wird. Die Frequenz, mit der die zweite Zufallszahl erzeugt wird, ist dann kleiner als die Frequenz, mit der eine dritte Zufallszahl aus der zweiten Zufallszahl erzeugt wird.

Das Umwandeln der erzeugten zweiten binären Zufallszahl in eine dritte binäre Zufallszahl kann also gemäß einer dritten Frequenz geschehen. Die Sicherheit kann dadurch weiter verbessert werden, weil die so erzeugte Zufallszahl dann auch von der dritten Frequenz abhängt.

Die dritte Frequenz kann also größer als die zweite Frequenz sein. Es kann so die Geschwindigkeit vergrößert werden, um eine Zufallszahl mit einer gewünschten Anzahl an Bits pro Zeiteinheit erzeugen zu können.

Das erste und/oder das zweite Eingangssignal können ein analoges Signal sein. Das erste und/oder das zweite Eingangssignal können ein Messsignal sein. Das Messsignal kann eine physikalische Größe eines Systems oder eines Bauteils sein, die gemessen wird. Es kann beispielsweise eine elektrische Spannung, eine elektrische Stromstärke, ein Druck, eine Temperatur oder ein Schallpegel gemessen werden, um ein ersten und/oder ein zweites Eingangssignal zu erhalten, das sich mit der Zeit ändert. Das erste und/oder das zweite Eingangssignal können ein elektrisches Signal sein.

Das erste und/oder das zweite Eingangssignal können sich mit der Zeit ändern, weil sich eine oder mehrere physikalische Größen des Systems oder des Bauteils mit der Zeit ändern.

Das erste und/oder das zweite Eingangssignal können sich aufgrund von Rauschen beim Messgerät mit der Zeit ändern. Rauschen bei einem Messgerät kann auf unerwünschten elektrischen Signalinterferenzen, thermischen Rauschen von Bauteilen oder auf anderen Störungen beruhen, die während einer Messung auftreten. Rauschen kann die Genauigkeit der Messung beeinträchtigen, indem es die tatsächlichen Messwerte verfälscht. Aufgrund von Rauschen kann ein Messwert schwanken.

Um ein Eingangssignal zu erzeugen, das sich mit der Zeit zufällig ändert, kann der Widerstandswert eines elektrischen Widerstands gemessen werden. Es kann der Widerstandswert eines Memristors ausgelesen werden. Ein Memristor ist ein passives elektrisches Bauelement, dessen Widerstandswert von der Höhe und Richtung eines zuvor durchflossenen elektrischen Stroms abhängt.

Besonders geeignet ist ein Memristor, dessen eingestellter Widerstandswert zwischen zumindest zwei verschiedenen Zuständen im Verlaufe der Zeit hin- und herspringen kann. Dafür geeignet ist ein VCM Memristor. Ein VCM Memristor arbeitet durch Veränderung der elektrischen Leitfähigkeit von Materialien und ermöglicht, Speicherzellen mit hoher Dichte zu realisieren. Ein bei einem VCM Memristor eingestellter Widerstandswert kann zwischen zumindest zwei verschiedenen Werten hin und herspringen und sich damit mit der Zeit ändern.

Wird der Widerstandswert des VCM Memristors gemessen, dann ändert sich das Messsignal mit der Zeit einerseits aufgrund der Eigenschaft des Memristors, zwischen wenigstens zwei Widerstandswerten hin- und herzuspringen. Außerdem ändert sich das gemessene Signal aufgrund von Rauscheffekten. Es wird so also ein sich zeitlich zufällig änderndes Signal erzeugt, welches schwankt. Es kann so ein analoges Eingangssignal erzeugt werden, welches zufällig in besonders gut geeigneter Weise schwanken kann.

Metalloxide ermöglichen ein resistives Schalten durch eine reversible redoxbasierte Valenzänderung zwischen dem hohen und dem niedrigen Valenzzustand des Metalls. Bauelemente, die eine Metall-Isolator-Metall-Struktur (MIM) aufweisen, wobei der Isolator etwa ein Phasenwechselmaterial (PCM) oder ein Valenzänderungsmaterial (VCM) sein kann, werden als Memristoren bezeichnet. Sie zeigen Hysterese-I-U-Kurven, bei denen die verschiedenen Steigungen der Kurven unterschiedliche Werte im Widerstand darstellen, die es ermöglichen, die binären Informationen "1" und "0" zu kodieren. Ein VCM Memristor umfasst ein Valenzänderungsmaterial als Isolator.

VCM Materialien mit großem energetischem Abstand zwischen Leitungsband und defect states sind besonders geeignet. Diese weisen eine besonders geeignete Störsignalstruktur auf.

Das erste Signal kann zeitlich verzögert mit sich selbst verglichen werden. Als zweites Signal dient dann das zeitlich verzögerte erste Signal. Es muss nur eine physikalische Größe gemessen werden, was den Aufwand für Hardware gering Dies ist aber weniger zu bevorzugen, da der technische Aufwand größer ist und die jeweiligen Mittelwerte gut aufeinander abgestimmt werden müssten.

Eine Umwandlung einer erzeugten binären Zufallszahl in eine andere binäre Zufallszahl kann durch ein Exklusiv-Oder-Gatter, auch XOR-Gatter (von englisch eXclusive OR ,exklusives Oder', "entweder oder") genannt, durchgeführt werden. Ein Exklusiv-Oder-Gatter ist ein Gatter, also eine elektronische Schaltung, mit zwei Eingängen und einem Ausgang, bei dem der Ausgang logisch "1" ist, wenn an nur einem Eingang "1" anliegt und an dem anderen "0".

Ein Zufallszahlengenerator zur Erzeugung einer Zufallszahl, insbesondere einer kryptographisch geeigneten Zufallszahl, kann gemäß dem zuvor beschriebenen Verfahren arbeiten. Der Zufallszahlengenerator kann einen Memristor und ein Messgerät für ein Auslesen eines Widerstandswerts des Memristors umfassen, um ein Eingangssignal erzeugen zu können, das sich mit der Zeit zufällig ändert. Durch das Messgerät kann beispielsweise ein elektrischer Strom gemessen werden, der durch den Memristor bei einer vorgegebenen elektrischen Spannung fließt. Der elektrische Strom ist dann ein Maß für den Widerstand des Memristors.

Der Zufallszahlengenerator kann eine Verzögerungseinrichtung umfassen, die das erzeugte Eingangssignal zeitlich verzögert, um so ein zweites Eingangssignal erhalten zu können. Alternativ kann der Zufallsgenerator eine Einrichtung umfassen, mit der ein zweites Eingangssignal unabhängig vom ersten Eingangssignal erzeugt werden kann. Die Einrichtung zur Erzeugung eines zweiten Eingangssignals kann zum Beispiel einen zweiten Memristor und ein zweites Messgerät umfassen. Dies ist aber weniger zu bevorzugen, da der technische Aufwand größer ist.

Der Zufallszahlengenerator kann einen Komparator umfassen, der das erste Eingangssignal mit dem zweiten Eingangssignal vergleicht, also zum Beispiel mit dem zeitlich verzögerten ersten Eingangssignal. Durch den Komparator kann dann durch Vergleich der Eingangssignal pro Takt einer ersten Frequenz ein Bit einer ersten Zufallszahl erzeugt werden. Es können also Bits einer ersten Zufallszahl gemäß einer ersten Frequenz erzeugt werden.

Der Zufallszahlengenerator kann eine erste Verarbeitungseinrichtung umfassen, die Bits der ersten erzeugten Zufallszahl gemäß einer zweiten Frequenz in Bits einer zweiten Zufallszahl umwandeln kann.

Der Zufallszahlengenerator kann eine zweite Verarbeitungseinrichtung umfassen, die Bits der zweiten erzeugten Zufallszahl gemäß einer dritten Frequenz in Bits einer dritten Zufallszahl umwandeln kann.

Die Frequenzen können sich unterscheiden.

Die erste Frequenz kann kleiner als die zweite Frequenz sein.

Die zweite Frequenz kann kleiner als die dritte Frequenz sein.

Eine Verarbeitungseinrichtung kann ein Exklusiv-Oder-Gatter sein.

Ein Verarbeitungseinrichtung kann ein Schieberegister sein. Das Schieberegister kann ein nichtlineares Schieberegister sein.

Der Memristor kann ein VCM Memristor sein.

Die Verzögerungseinrichtung kann ein RC Glied sein.

Es können durch die Erfindung Zufallszahlen erzeugt werden, die für kryptographische Anwendungen geeignet sind. Eine erzeugte Zufallszahl kann für das Verschlüsseln einer rechnerinternen Kommunikation verwendet werden. Eine erzeugte Zufallszahl kann an eine Software basierte Anwendung weitergeleitet werden. Eine erzeugte Zufallszahl kann für Rechenansätze verwendet werden, die Zufallszahlen einsetzen. Der technische Aufwand für die Erzeugung einer solchen Zufallszahl und die dafür erforderliche Hardware ist gering. Eine so erzeugte Zufallszahl besteht beispielsweise den NIST-Test. Ein NIST-Test bezieht sich auf eine Bewertungsmethode, die von der National Institute of Standards and Technology (NIST) in den USA entwickelt wurde. Ein NIST Test dient zur Bewertung von Sicherheitsstandards.

### Nachfolgend wird die Erfindung anhand von Beispielen näher erläutert

Es zeigen
- Figur 1:: Schema für ein Erzeugen einer zufälligen Zahl mithilfe eines analogen Signals.
- Figur 2:: erste Schaltung zur Erzeugung einer zufälligen Zahl.
- Figur 3:: zweite Schaltung zur Erzeugung einer zufälligen Zahl.
- Figur 4:: vierte Schaltung zur Erzeugung einer zufälligen Zahl
- Figur 5:: Fibonacci NLFSR.

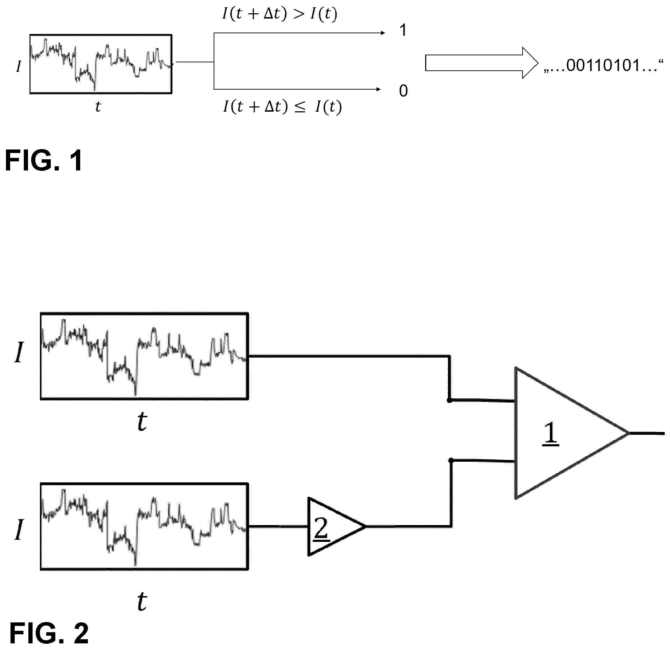

Die Figur 1 zeigt das Erzeugen einer zufälligen Zahl mithilfe eines sich zeitlich verändern Messsignals I. Das in der Figur 1 links gezeigte Messsignal I schwankt . Das Messsignal I kann das Messsignal eines elektrischen Stroms sein, der durch einen Memristor fließt. Schwankungen des Messsignals I können auf dem Verhalten des Memristors beruhen und/oder auf dem Verhalten des verwendeten Strommessgeräts.

Um aus diesem Messsignal I eine zufällige Zahl zu erzeugen, wird das Messsignal I zum Zeitpunkt t mit dem Messsignal zum Zeitpunkt t+Δt verglichen, also zu einem späteren Zeitpunkt. Ist I(t + Δt) > I(t), dann wird ein Signal "high" erzeugt, also eine logische "1". Ist I(t + Δt) ≤ I(t), dann wird ein Signal "low" erzeugt, also eine logische "0". Das Messignal ist also das erste Eingangssignal. Das zeitlich verzögerte Messsignal ist das zweite Eingangssignal.

Ist auf diese Weise ein Signal erzeugt worden, welches eine logische 1 oder eine logische 0 ist, dann wird das Messsignal I getaktet zu einem neuen Zeitpunkt t mit dem Messsignal zum Zeitpunkt t+Δt verglichen, um ein nächstes Signal zu erzeugen, welches eine logische 1 oder eine logische 0 ist. Es entsteht so eine zufällige Folge von erzeugten Signalen "high" und "low" und damit eine zufällige Folge von logischen Nullen und Einsen, wie dies auf der rechten Seite der Figur 1 angedeutet wird.

Die Figur 2 skizziert eine Schaltung zur Erzeugung einer zufälligen Zahl. Das in der Figur 1 gezeigte Messsignal I wird einerseits unmittelbar an einen Eingang eines Komparators 1 angelegt. Andererseits wird das in der Figur 1 gezeigte Messsignal I mithilfe eines Verzögerungsglieds 2 zeitlich verzögert an den anderen Eingang des Komparators 1 angelegt.

Der Komparator 1 ist ein Schaltkreis, der die beiden Messsignale aufnimmt und seinen Ausgang gemäß des stärkeren Messsignals schaltet. Am Ausgang des Komparators steht dann ein elektrisches Ausgangssignal zur Verfügung, das in Abhängigkeit von den beiden aufgenommenen Messsignalen bzw. Eingangssignalen "high" oder "low" sein kann.

Das Verzögerungsglied 2 kann ein RC Glied sein. Zwar kann durch ein RC Glied das Messsignal I geringfügig verändert werden. Eine solche geringfügige Änderung ist jedoch nicht von praktischer Relevanz, wie Versuche gezeigt haben.

Durch den in der Figur 2 gezeigten Schaltkreis kann zwar auf diese Weise eine zufällige Zahl erzeugt werden. Allerdings ist die Geschwindigkeit, mit der eine zufällige Zahl erzeugt werden kann, durch die Frequenz limitiert, mit der die in der Figur 2 gezeigte Schaltung betrieben werden kann. Außerdem kann es genügen, das Messsignal zu kennen, um die erzeugte zufällige Zahl unbefugt ermitteln zu können.

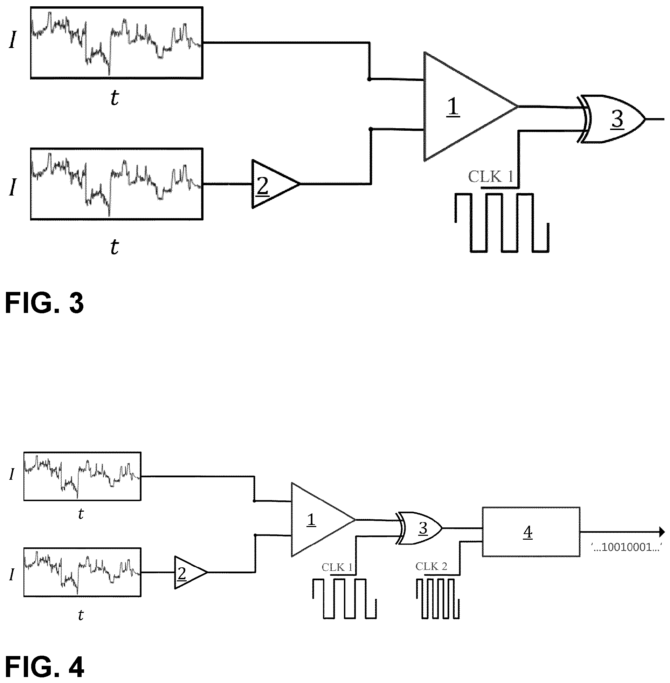

Um dies zu ändern, kann der Schaltkreis um ein XOR Gatter 3 erweitert werden, wie dies in der Figur 3 gezeigt wird. An einem Eingang des XOR Gatters 3 liegt das Ausgangssignal des Komparators 1 an. An dem anderen Eingang des XOR Gatters 3 liegt ein Taktsignal CLK 1 an.

Das XOR Gatter vergleicht das Ausgangssignal des Komparators mit dem Taktsignal CLK 1. In Abhängigkeit von dem Vergleich erzeugt das XOR Gatter an seinem Ausgang ein Ausgangssignal, das "high" oder "low" sein kann, welches also einer "0" oder einer "1" entspricht. Es entsteht so eine zufällige Abfolge von Signalen "high" und "low" und damit eine zufällige Folge von logischen Nullen und logischen Einsen, die nicht nur vom Messsignal I abhängt, sondern außerdem von der Frequenz des Taktsignals CLK 1. Um die so am Ausgang des XOR Gatters zufällig erzeugte Zahl ermitteln zu können, genügt es dann nicht mehr, das Messsignal I zu kennen. Die Sicherheit, dass ein unbefugter Dritter die erzeugte zufällige Zahl nicht ermitteln kann, wird so verbessert.

Ist die Frequenz CLK 1 größer als die Frequenz, mit der am Ausgang des Komparators 1 eine zufällige Folge von Signalen "high" und "low" entsteht, dann kann dadurch auch die Geschwindigkeit vergrößert werden, mit der eine zufällige Zahl erzeugt werden kann.

In der Figur 4 wird eine weitere Schaltung zur Erzeugung einer Zufallszahl gezeigt, durch die Sicherheit und/oder die Geschwindigkeit für die Erzeugung einer Zufallszahl weiter verbessert werden kann. Um dies erreichen zu können, kann die Schaltung ein nichtlineares Schieberegister 4 umfassen. In das nichtlineare Schieberegister 4 werden die Bits beispielsweise seriell hineingeschoben, die zuvor erzeugt wurden, also die durch das XOR Gatter 3 erzeugt wurden. Das nichtlineare Verschieberegister kann die Bits gemäß einer dritten Frequenz CLK 2 verschieben. Die dritte Frequenz CLK zwei kann größer als die zweite Frequenz CLK eins sein, mit der das XOR Gatter 3 eine zweite Zufallszahl erzeugt.

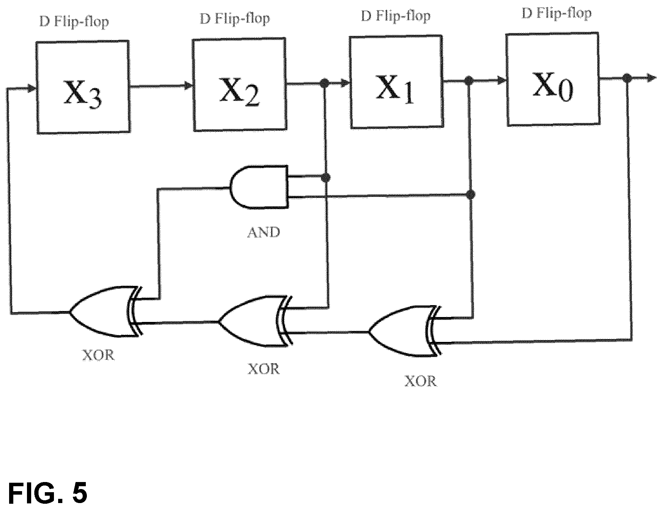

Das nichtlineare Schieberegister 4 kann ein 4-bit Fibonacci NLFSR sein. Ein 4-bit Fibonacci NLFSR (Non-Linear Feedback Shift Register) ist eine spezielle Art von Schieberegister mit vier Speicherzellen, das nach dem Fibonacci-LFSR-Prinzip arbeitet. In einem Fibonacci NLFSR werden die Inhalte der Speicherzellen nicht einfach zyklisch verschoben, sondern es gibt nichtlineare logische Verknüpfungen zwischen den Bits in den einzelnen Speicherzellen. Diese nichtlinearen Verknüpfungen werden oft durch eine spezielle Rückkopplungsfunktion oder durch einen speziellen Feedback-Mechanismus realisiert, der es dem Register ermöglicht, pseudozufällige Bitfolgen zu erzeugen. Ein 4-bit Fibonacci NLFSR wird in der Figur 5 gezeigt. Es umfasst vier D Flip Flops X0 bis X3 und drei XOR Gatter.

Eine so erzeugte Zufallszahl hat einschlägige Tests bestanden, mit denen die Geeignetheit für kryptographische Anwendungen geprüft wird.

## Patentansprüche

1. Verfahren zur Erzeugung einer Zufallszahl mit den Schritten:
ein erstes Eingangssignal (I(t)) wird erzeugt, das sich mit der Zeit (t) zufällig ändert,
ein zweites Eingangssignal (I(t+Δt) wird erzeugt, das sich mit der Zeit zufällig ändert,
das erste Eingangssignal (I(t)) wird mit dem zweiten Eingangssignal (I(t+Δt) verglichen,
in Abhängigkeit von dem Ergebnis des Vergleichs wird entweder eine erste logische 0 oder eine erste logische 1 erzeugt und damit ein erstes Bit einer binären Zufallszahl,
nach dem Erzeugen des ersten Bits der binären Zufallszahl werden die Schritte mehrfach wiederholt, um weitere Bits der binären Zufallszahl zu erzeugen.

2. Verfahren nach dem vorhergehenden Anspruch, **dadurch gekennzeichnet, dass** die erzeugte binäre Zufallszahl in eine zweite binäre Zufallszahl umgewandelt wird.

3. Verfahren nach dem vorhergehenden Anspruch, **dadurch gekennzeichnet, dass** während des Taktes einer ersten Frequenz eine Stelle der ersten erzeugten Zufallszahl gemäß einer zweiten Frequenz (CLK 1) in eine Stelle der zweiten binäre Zufallszahl umgewandelt wird, wobei sich die erste Frequenz von der zweiten Frequenz (CLK 1) unterscheidet.

4. Verfahren nach dem vorhergehenden Anspruch, **dadurch gekennzeichnet, dass** die zweite Frequenz (CLK 1) größer als die erste Frequenz ist.

5. Verfahren nach einem der drei vorhergehenden Ansprüche, **dadurch gekennzeichnet, dass** die erzeugte zweite binäre Zufallszahl in eine dritte binäre Zufallszahl umgewandelt wird.

6. Verfahren nach dem vorhergehenden Anspruch, **dadurch gekennzeichnet, dass** die zweite binäre Zufallszahl durch ein nichtlineares Schieberegister (4) in eine dritte binäre Zufallszahl umgewandelt wird.

7. Verfahren nach einem der beiden vorhergehenden Ansprüche, **dadurch gekennzeichnet, dass** die Umwandlung von der zweiten in die dritte Zufallszahl gemäß einer dritten Frequenz (CLK 2) erfolgt, die größer als die zweite Frequenz (CLK 1) ist.

8. Verfahren nach einem der vorhergehenden Ansprüche, **dadurch gekennzeichnet, dass** das erste Eingangssignal (I(t)) und das zweite Eingangssignal (I(t+Δt) Messsignale einer physikalischen Größe sind.

9. Verfahren nach dem vorhergehenden Anspruch, **dadurch gekennzeichnet, dass** die physikalische Größe der elektrische Widerstand eines VCM Memristors ist.

10. Verfahren nach einem der beiden vorhergehenden Ansprüche, **dadurch gekennzeichnet, dass** das zweite Eingangssignal (I(t+Δt) das zeitlich verzögerte erste Eingangssignal (I(t)) ist.

11. Verfahren nach einem der vorhergehenden Ansprüche, **dadurch gekennzeichnet, dass** eine binäre Zufallszahl in eine andere binäre Zufallszahl durch ein Exklusiv-Oder-Gatter (3) umgewandelt wird.

12. Zufallszahlengenerator zur Erzeugung einer Zufallszahl gemäß einem Verfahren nach einem der vorhergehenden Ansprüche mit einem Memristor und einem Messgerät für ein Auslesen eines Widerstandswerts des Memristors zur Erzeugung eines Eingangssignals (I(t), das sich mit der Zeit zufällig ändert,
mit einer Verzögerungseinrichtung (2), die das erzeugte Eingangssignal (I(t) zeitlich verzögert,
mit einem Komparator (1), der das Eingangssignal I(t)) mit dem zeitlich verzögerten Eingangssignal (I(t+Δt) vergleicht und der durch Vergleiche Bits einer ersten Zufallszahl gemäß einer ersten Frequenz erzeugt,
mit einer ersten Verarbeitungseinrichtung (3), die Bits der ersten erzeugten Zufallszahl gemäß einer zweiten Frequenz (CLK 1) in Bits einer zweiten Zufallszahl umwandelt,
mit einer zweiten Verarbeitungseinrichtung (4), die Bits der zweiten erzeugten Zufallszahl gemäß einer dritten Frequenz (CLK 2) in Bits einer dritten Zufallszahl umwandelt,
wobei die erste Frequenz kleiner als die zweite Frequenz (CLK 1) ist,
wobei die zweite Frequenz (CLK 1) kleiner als die dritte Frequenz (CLK 2) ist.

13. Zufallsgenerator nach dem vorhergehenden Anspruch, **dadurch gekennzeichnet, dass** die eine Verarbeitungseinrichtung ein Exklusiv-Oder-Gatter (3) ist.

14. Zufallsgenerator nach einem der zwei vorhergehenden Ansprüche, **dadurch gekennzeichnet, dass** die andere Verarbeitungseinrichtung ein nichtlineares Schieberegister (4) ist.

15. Zufallsgenerator nach einem der drei vorhergehenden Ansprüche, **dadurch gekennzeichnet, dass** der Memristor ein VCM Memristor ist und/oder die Verzögerungseinrichtung ein RC Glied (2) ist.
